# EUROPEAN PATENT APPLICATION

(11) **EP 4 772 302 A1**
(43) Date of publication of application: **08.07.2026**
(21) Application number: 24857662.1
(22) Date of filing: 28.02.2024
(51) Int. Cl.: B23K 26/06, B23K 26/073, G02B 27/09

(54) **LASER LIGHT SOURCE AND MACHINING DEVICE**

(30) Priority: 01.09.2023 CN 202311138198
(71) Applicant: YLX Incorporated, Shenzhen, Guangdong 518000 (CN)
(72) Inventor: CHEN, Bin, Guangdong 518000 (CN); ZHANG, Xiaojian, Guangdong 518000 (CN)
(74) Representative: Metida
(86) International application number: PCT/CN2024/078934
(87) International publication number: WO 2025/044107

(57) **Abstract**

A laser light source includes: a laser unit (1), used for emitting a laser beam (10), the laser beam (10) having a first divergence angle in a fast axis direction greater than a second divergence angle in a slow axis direction; a collimating element (3), arranged on an optical path of the laser beam (10) and used for collimating the laser beam (10) in the fast axis direction of the laser beam (10); a diffusion element (4), used for receiving the laser beam (10) from the collimating element (3) and diffusing the laser beam (10) in the fast axis direction of the laser beam (10), so as to increase the divergence angle of the laser beam (10) to a third divergence angle smaller than the first divergence angle; and a focusing element (2), used for focusing the laser beam (10) from the diffusion element (4).

## Description

### TECHNICAL FIELD

The present disclosure relates to the field of laser processing technology, and in particular to a laser light source and a machining device.

### BACKGROUND

It is known that a laser beam has a fast axis direction and a slow axis direction, wherein a divergence of the laser beam in the fast axis direction is greater than a divergence of the laser beam in the slow axis direction, so that the laser beam forms an elliptical light spot when propagating to the far field. That is, the light spot size of the laser beam in the fast axis direction is greater than the light spot size of the laser beam in the slow axis direction.

In scenarios such as laser processing, the fast axis direction and the slow axis direction of the laser beam are generally collimated, and then the laser beam collimated in both the fast axis direction and the slow axis direction is focused to a same point by a focusing lens. However, this optical path has certain deficiencies: the light spot corresponding to the fast axis direction at the focal point is significantly larger than the light spot corresponding to the slow axis direction at the focal point, resulting in relatively low power density at the focal point.

### SUMMARY

The purpose of the present disclosure is to provide a laser light source to increase the power density of the laser beam at the focal point.

To achieve the above purpose, in a first aspect, an embodiment of the present disclosure provides a laser light source, including:
a laser unit configured to emit a laser beam, wherein the laser beam has a first divergence angle in a fast axis direction and a second divergence angle in a slow axis direction, and the first divergence angle is greater than the second divergence angle;
a collimating element on an optical path of the laser beam and configured to collimate the laser beam in the fast axis direction of the laser beam;
a diffusion element configured to receive the laser beam from the collimating element and diffuse the laser beam in the fast axis direction of the laser beam, such that a divergence angle of the laser beam is increased to a third divergence angle, and the third divergence angle is less than the first divergence angle; and
a focusing element configured to focus the laser beam from the diffusion element.

In some possible embodiments, the diffusion element includes an optical medium configured to transmit the laser beam, and the optical medium is provided with an optical curved surface configured to diffuse the laser beam in the fast axis direction.

In some possible embodiments, the optical curved surface is curved in a cross-section defined by the fast axis direction of the laser beam, and the optical curved surface is straight in a cross-section defined by the slow axis direction of the laser beam.

In some possible embodiments, the optical curved surface is on an incident surface of the optical medium, and the optical curved surface is curved toward an interior direction of the optical medium.

In some possible embodiments, an exit surface of the optical medium is a planar surface.

In some possible embodiments, the laser light source includes a plurality of the laser units configured to emit a plurality of the laser beams, wherein the plurality of laser beams is incident on the diffusion element, and the plurality of the laser beams is symmetrical with respect to a central axis of the diffusion element.

In some possible embodiments, the laser light source further includes a light guiding element between the diffusion element and the collimating element and configured to change a propagation direction of the laser beam.

In some possible embodiments, the diffusion element is on an optical axis of the focusing element, and a position of the diffusion element relative to the focusing element is adjustable, such that an intersection point of extension lines of the laser beam in the fast axis direction and an intersection point of the laser beam in the slow axis direction are at a same point.

In some possible embodiments, the diffusion element is on an optical axis of the focusing element, and a position of the diffusion element relative to the focusing element is adjustable, such that a size of a light spot of the laser beam incident on the focusing element and a size of a light spot of the laser beam propagating in the slow axis direction incident on the focusing element are substantially same.

In a second aspect, an embodiment of the present disclosure provides a machining device comprising the laser light source as described above.

### Beneficial effects of the present disclosure:

In the laser light source according to the embodiments of the present disclosure, a collimating element and a diffusion element are arranged between the laser unit and the focusing element to collimate and diffuse the laser beam in the fast axis direction, thereby reducing the size of the light spot in the fast axis direction converged to the focal point through the focusing element, so as to increase the power density at the focal point.

### BRIEF DESCRIPTION OF THE DRAWINGS

In order to more clearly illustrate the technical solutions in the embodiments of the present disclosure, the drawings required for describing the embodiments will be briefly introduced below. Obviously, the drawings described below are merely some embodiments of the present disclosure. For those of ordinary skill in the art, other drawings can also be obtained based on these drawings without creative efforts, wherein:
FIG. 1 is a schematic diagram of an optical path structure of a laser light source according to an embodiment of the present disclosure in a first direction;
FIG. 2 is a schematic diagram of an optical path structure of the laser light source according to the embodiment of the present disclosure in a second direction.

### DETAILED DESCRIPTION

The technical solutions in the embodiments of the present disclosure will be clearly and completely described below with reference to the drawings in the embodiments of the present disclosure. Obviously, the embodiments described are some, but not all, embodiments of the present disclosure. Based on the embodiments of the present disclosure, all other embodiments obtained by those of ordinary skill in the art without creative efforts fall within the protection scope of the present disclosure.

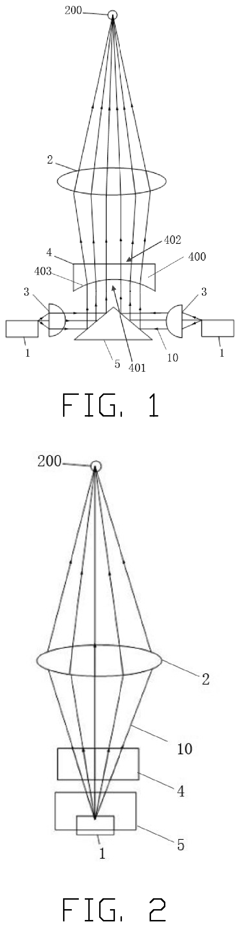

Referring to FIGS. 1 and 2, an embodiment of the present disclosure provides a laser light source, including a laser unit 1, a focusing element 2, a collimating element 3, and a diffusion element 4.

The laser unit 1 includes a semiconductor laser element, such as a laser diode. The laser unit 1 is configured to emit a laser beam 10, wherein the laser beam 10 has a first divergence angle in a fast axis direction and a second divergence angle in a slow axis direction, the first divergence angle is greater than the second divergence angle.

The focusing element 2 is on an optical path of the laser beam 10 and configured to focus the laser beam 10 to a focal point 200. The focusing element 2 may be selected as a focusing lens, which can converge the incident laser beam 10 to the focal point 200 behind the focusing lens. In some optional embodiments, the focusing element 2 may be selected as a single lens element or a plurality of cascaded lens elements.

The collimating element 3 is on an exit optical path of the laser beam 10 and configured to collimate the laser beam 10 in the fast axis direction of the laser beam 10. The collimating element 3 may be selected as, for example, a cylindrical lens, which has collimation property in the fast axis direction of the laser beam 10 and does not change the divergence angle of the laser beam 10 in the slow axis direction.

The diffusion element 4 is on the optical path of the laser beam 10 between the collimating element 3 and the focusing element 2. The diffusion element 4 is configured to diffuse the laser beam 10 in the fast axis direction of the laser beam 10 and increase the divergence angle of the laser beam 10 in the fast axis direction to a third divergence angle, wherein the third divergence angle is less than the first divergence angle.

In the related art, after successively collimating the laser beam in the fast axis direction and the slow axis direction, the laser beam is converged to the focal point by the focusing element. Since the light spot emitted after collimation in the fast axis direction has a relatively small size in the fast axis direction, the light spot converged at the focal point by the focusing element has a larger size in the fast axis direction, thereby resulting in lower power density. In the embodiments of the present disclosure, after collimating the laser beam in the fast axis direction, the divergence angle of the laser beam in the fast axis direction is increased by the diffusion element, so that the size of the light spot in the fast axis direction converged at the focal point by the focusing element is reduced, thereby increasing the power density at the focal point.

It can be understood that, after collimation in the fast axis direction by the collimating element 3, the laser beam 10 in the fast axis direction is changed to propagate toward the focusing element 2 as parallel light or quasi-parallel light. At this time, the laser beam 10 in the fast axis direction is equivalent to a point light source emitted from a light-emitting point at infinity. In order to make the focusing element 2 converge the fast axis direction and the slow axis direction of the laser beam 10 to the same focal point 200, one way is to also collimate the slow axis direction of the laser beam 10, which is adopted in the related art, but this will cause the light spot at the focal point to have a larger size in the fast axis direction, thereby resulting in lower power density. In the embodiment of the present disclosure, after the laser beam 10 collimated in the fast axis direction by the collimating element 3 passes through the diffusion element 4 again, the divergence angle of the laser beam 10 in the fast axis direction is increased, so that the laser beam is projected to the focusing element 2 with a third divergence angle less than the first divergence angle. Thus, after passing through the diffusion element 4, the reverse extension lines of the respective rays of the laser beam 10 in the fast axis direction intersect at an intersection point, that is, the laser beam 10 in the fast axis direction is equivalent to a divergent beam emitted from the intersection point as a light-emitting point. Therefore, while the size of the light spot in the fast axis direction of the laser beam 10 converged to the focal point by the focusing element 2 is reduced, the position of the focal point where the fast axis direction of the laser beam 10 is converged by the focusing element 2 also changes.

In the embodiment of the present disclosure, the laser beam 10 is configured to be projected to the focusing element 2 as a divergent beam in the slow axis direction and converged to the focal point by the focusing element 2. In the slow axis direction of the laser beam 10, it can be equivalent to a divergent beam projected from a light-emitting point to the focusing element 2.

By configuring the position of the diffusion element 4 on the optical axis of the focusing element 2, the position of an equivalent light-emitting point of the laser beam 10 can be configured in the fast-axis direction of the laser beam 10. For example, when the diffusion element 4 moves on the optical axis of the focusing element 2, the position of the equivalent light-emitting point of the laser beam 10 in the fast axis direction changes synchronously with the position of the diffusion element 4, while the position of the equivalent light-emitting point of the laser beam 10 in the slow axis direction can remain unchanged. Therefore, the position of the diffusion element 4 on the optical axis of the focusing element 2 can be configured so that the equivalent light-emitting point of the laser beam 10 in the fast axis direction and the equivalent light-emitting point in the slow axis direction are at the same point. Thus, the fast axis direction and the slow axis direction of the laser beam 10 are focused to the same focal point 200 after passing through the focusing element 2.

By configuring the magnitude of the diffusing capability of the diffusion element 4 in the fast axis direction of the laser beam, the position of the equivalent light-emitting point of the laser beam 10 can be configured. For example, when the diffusion capability of the diffusion element 4 in the fast axis direction of the laser beam is greater, the equivalent light-emitting point in the fast axis direction of the laser beam will be farther away from the focusing element 2, and conversely closer to the focusing element 2, thereby enabling configuration of the position of the equivalent light-emitting point of the laser beam 10. On the other hand, by configuring the magnitude of the diffusion capability of the diffusion element 4 in the fast axis direction of the laser beam, the divergence angle of the laser beam 10 in the fast axis direction, that is, the magnitude of the third divergence angle, can be configured. When the magnitude of the third divergence angle is the same as or close to the second divergence angle (the divergence angle in the slow axis direction of the laser beam 10), and the equivalent light-emitting point in the fast axis direction of the laser beam 10 and the equivalent light-emitting point in the slow axis direction are at the same point, the laser beam 10 is focused to the same focal point 200 after passing through the focusing element 2. The focal point 200 forms a circular spot, that is, the light spot sizes in the fast axis direction and the slow axis direction are substantially equal, thereby increasing the power density at the focal point 200.

**In** some embodiments, the diffusion element 4 includes an optical medium 400 having an incident surface 401 and an exit surface 402, wherein the laser beam 10 is incident into the interior of the optical medium 400 from the incident surface 401 of the optical medium 400, propagates inside the optical medium 400, and finally exits from the exit surface 402 of the optical medium 400. The optical medium 400 may be selected from light-transmissive materials such as glass, plastic, PVC, or the like.

The optical medium 400 is configured to transmit the laser beam 10, and an optical curved surface 403 configured to diffuse the laser beam 10 in the fast axis direction is formed on the optical medium 400. That is, the laser beam 10 collimated in the fast axis direction by the collimating element 3 is incident on the optical medium 400 and diffused in the fast axis direction by the optical curved surface 403 formed on the optical medium 400, so as to increase the divergence angle of the laser beam 10 in the fast axis direction, and make the increased third divergence angle less than the original first divergence angle.

**In** some embodiments, the optical curved surface 403 is configured to be curved in a cross-section defined by the fast axis direction of the laser beam 10 (as shown in the cross-section in FIG. 1), so that when the laser beam 10 passes through the optical curved surface 403, the optical curved surface 403 utilizes its curved structure to increase the divergence angle of the laser beam 10 in the fast axis direction. The optical curved surface 403 may also be configured to be straight in a cross-section defined by the slow axis direction of the laser beam 10 (as shown in the cross-section in FIG. 2), so that when the laser beam 10 passes through the optical curved surface 403, the angle change in the slow axis direction occurs only due to refraction, and this portion of angle change can ultimately be eliminated by exiting from the exit surface 402 of the optical medium 400. For example, in some embodiments, the exit surface 402 of the optical medium 400 is a planar surface.

In some embodiments, the optical curved surface 403 is provided on the incident surface of the optical medium 400, and the optical curved surface 403 is curved toward the interior direction of the optical medium 400, that is, the optical curved surface 403 is configured as a concave structure formed on the incident surface 401 of the optical medium 400. After collimation in the fast axis direction, the laser beam 10 is incident on the concave structure as parallel light or quasi-parallel light in the fast axis direction, thereby diffusing the laser beam 10 in the fast axis direction. The direction extension lines of the diffused laser beam 10 in the fast axis direction intersect at the center of curvature of the concave structure or approximately intersect at the center of curvature of the concave structure. Thus, after passing through the optical curved surface 403, the laser beam 10 in its fast axis direction is equivalent to a laser beam projected toward the focusing element 2 with the center of curvature as a light-emitting point.

In some embodiments, the exit surface 402 of the optical medium 400 is a planar surface. Therefore, the optical medium 400 as a whole exhibits the shape of a concave cylindrical element, which can increase the divergence angle of the laser beam 10 in the fast axis direction of the laser beam 10 and transmit the laser beam 10 in the slow axis direction of the laser beam 10 without changing the divergence angle of the laser beam 10.

In some embodiments, the laser light source includes a plurality of the laser units 1 configured to emit a plurality of the laser beams 10 respectively, and the plurality of the laser beams 10 are all incident on the diffusion element 4, wherein the plurality of laser beams 10 are symmetrical with respect to a central axis of the diffusion element.

Specifically, the plurality of laser units 1 emit a plurality of the laser beams 10 respectively, the plurality of laser beams 10 pass through the collimating element 3 respectively and are collimated in their respective fast axis directions, then the plurality of laser beams 10 are all incident on the diffusion element 4, and after the divergence angles in the fast axis directions of the respective laser beams 10 are increased by the diffusion element 4, they are focused by the focusing element 2 to the same focal point 200. Since in this embodiment, the laser beams 10 emitted from the plurality of the laser units 1 are simultaneously focused to the same focal point 200, the power density at the focal point 200 is further increased.

The central axis of the diffusion element 4 can be understood as a straight line defined by the optical axis of the diffusion element 4, or, for example, a straight line defined by its geometric central axis in the structure of the diffusion element 4 as shown in FIG. 1. By configuring the plurality of the laser beams 10 emitted from the plurality of the laser units 1 to be symmetrical with respect to the central axis of the diffusion element 4, the combination of the light spots where the plurality of the laser beams 10 are incident on the diffusion element 4 forms a circular spot region, and therefore, they are finally focused to the same focal point 200 by the focusing element 2.

In some specific embodiments, a number of laser units 1 may be set to two, the laser beams 10 emitted from the two laser units 1 respectively have the same fast axis direction and slow axis direction, and the two laser units 1 are arranged along the fast axis direction of the laser beams 10 emitted therefrom, and the two laser beams 10 are symmetrical with respect to the central axis of the diffusion element 4.

In some embodiments, the laser light source further includes a light guiding element 5 between the collimating element 3 and the diffusion element 4 and configured to change the propagation direction of the laser beam 10. For example, as shown in FIG. 1, the laser unit 1 emits the laser beam 10 in a horizontal direction, the laser beam 10 passes through the collimating element 10 for fast axis collimation 10, then passes through the light guiding element 5 to change the propagation direction, and changes the propagation direction of the laser beam 10 to upward, and incident upward on the diffusion element 4. By changing the direction of the laser beam 10, the space volume is reasonably utilized, and the overall volume is reduced.

**In** some specific embodiments, the light guiding element 5 may be selected as a reflective element, such as a reflective mirror. In the embodiment shown in FIG. 1, the light guiding element 5 is illustrated as a reflective prism having a plurality of reflective surfaces, so that the light guiding element 5can simultaneously reflect the plurality of the laser beams 10 emitted from the plurality of the laser units 1. It should be noted that, in some other embodiments, the light guiding element 5 may be integrated with the collimating element 3. For example, a concave reflective element is arranged between the laser unit 1 and the diffusion element 4, the concave reflective element having curvature in the fast axis direction of the laser beam 10 to collimate and reflect the laser beam 10 in the fast axis direction, and the concave reflective element has no curvature in the slow axis direction of the laser beam 10, or is straight relative to the slow axis direction of the laser beam 10, so that the concave reflective element only reflects the laser beam 10 in the slow axis direction. Thus, the concave reflective element simultaneously achieves collimation in the fast axis direction of the laser beam 10 and changing the propagation direction of the laser beam 10.

**In** some embodiments, the laser unit 1 may be selected as a laser chip, such as an edge-emitting semiconductor laser chip. Therefore, the bottom surface of the laser unit 1 has a larger area, can be mounted on a heat dissipation layer structure, and maintains a larger contact area with the heat dissipation layer structure, thereby obtaining good heat dissipation capability. The manner in which the bottom surface of such a laser chip is surface-mounted and the laser beam is emitted from the side can realize SMD packaging of the laser chip, which is beneficial to reducing the overall volume.

As described above, by configuring the position of the diffusion element 4 on the optical axis of the focusing element 2, the position of the equivalent light-emitting point of the laser beam 10 can be configured in the fast axis direction of the laser beam 10. In some embodiments, the diffusion element 4 can be arranged on the optical axis of the focusing element 2, and the position of the diffusion element 2 relative to the focusing element 2 is adjustable.

In some embodiments, the position of the diffusion element 4 relative to the focusing element 2 is adjusted such that an intersection point defined by the extension lines in the fast axis direction of the laser beam 10 diffused by the diffusion element 4 and an intersection point defined in the slow axis direction of the laser beam 10 are at the same point. Thus, the laser beam 10 is equivalent to being projected from the same point, and therefore is focused to the same focal point 200 by the focusing element 2, thereby increasing the power density at the focal point 200.

In some embodiments, the position of the diffusion element 4 relative to the focusing element 2 is adjusted such that the light spot sizes of the laser beam 10 incident on the focusing element 2 in the fast axis direction and the slow axis direction are substantially the same. This allows the laser beam 10 to form a circular spot as much as possible, and therefore the focal point 200 focused after passing through the focusing element 2 forms a spherical space, so that the light spot sizes in all directions at the focal point 200 are substantially the same, thereby increasing the power density at the focal point 200.

**In** some embodiments, the position of the diffusion element 4 relative to the focusing element 2 is adjusted such that divergence angles of the laser beam 10 incident on the focusing element 2 in the fast axis direction and the slow axis direction are substantially equal in magnitude. This is also beneficial to making the laser beam 10 to form a circular spot as much as possible, and therefore the light spot sizes in all directions at the focal point 200 focused after passing through the focusing element 2 are substantially the same, thereby increasing the power density at the focal point 200.

**In** some embodiments, the laser light source includes an adjusting element (not shown) connected to the diffusion element 4 to drive the diffusion element 4 to move on the optical axis of the focusing element 2. Thus, the position of the diffusion element 4 on the optical axis of the focusing element 2 can be adjusted by the adjusting element. The adjusting element may be selected as, for example, an electric slider, a manual slider, a threaded push rod, or other position adjusting structures.

An embodiment of the present disclosure further provides a machining device including the laser light source as described above.

The machining device is applied, for example, to scenarios where high-energy laser is used for processing, such as laser cutting, laser engraving, etc., used in industrial processing, medical aesthetics, and other scenarios.

What has been described above are merely embodiments of the present disclosure. It should be pointed out here that, for those of ordinary skill in the art, improvements can be made without departing from the inventive concept of the present disclosure, but these all fall within the protection scope of the present disclosure.

## Claims

1. A laser light source comprising:
a laser unit configured to emit a laser beam, wherein the laser beam has a first divergence angle in a fast axis direction and a second divergence angle in a slow axis direction, and the first divergence angle is greater than the second divergence angle;
a collimating element on an optical path of the laser beam and configured to collimate the laser beam in the fast axis direction of the laser beam;
a diffusion element configured to receive the laser beam from the collimating element and diffuse the laser beam in the fast axis direction of the laser beam, such that a divergence angle of the laser beam is increased to a third divergence angle, and the third divergence angle is less than the first divergence angle; and
a focusing element configured to focus the laser beam from the diffusion element.

2. The laser light source according to claim 1, wherein the diffusion element comprises an optical medium configured to transmit the laser beam, and the optical medium is provided with an optical curved surface configured to diffuse the laser beam in the fast axis direction.

3. The laser light source according to claim 2, wherein the optical curved surface is curved in a cross-section defined by the fast axis direction of the laser beam, and the optical curved surface is straight in a cross-section defined by the slow axis direction of the laser beam.

4. The laser light source according to claim 2, wherein the optical curved surface is on an incident surface of the optical medium, and the optical curved surface is curved toward an interior direction of the optical medium.

5. The laser light source according to claim 4, wherein an exit surface of the optical medium is a planar surface.

6. The laser light source according to claim 1, comprising a plurality of the laser units configured to emit a plurality of the laser beams, wherein the plurality of the laser beams is incident on the diffusion element, and the plurality of the laser beams is symmetrical with respect to a central axis of the diffusion element.

7. The laser light source according to claim 1 or 6, further comprising a light guiding element between the diffusion element and the collimating element and configured to change a propagation direction of the laser beam.

8. The laser light source according to claim 1, wherein the diffusion element is on an optical axis of the focusing element, and a position of the diffusion element relative to the focusing element is adjustable, such that an intersection point of extension lines of the laser beam in the fast axis direction and an intersection point of extension lines of the laser beam in the slow axis direction are at a same point.

9. The laser light source according to claim 1, wherein the diffusion element is on an optical axis of the focusing element, and a position of the diffusion element relative to the focusing element is adjustable, such that a size of a light spot of the laser beam propagating in the fast axis direction incident on the focusing element and a size of a light spot of the laser beam propagating in the slow axis direction incident on the focusing element are substantially same.

10. A machining device comprising the laser light source according to any one of claims 1 to 9.
